(19) Europäisches Patentamt
European Patent Office
Office européen des brevets

(11) **EP 2 700 124 B1**

(12) **EUROPÄISCHE PATENTSCHRIFT**

(45) Veröffentlichungstag und Bekanntmachung des Hinweises auf die Patenterteilung:
**28.02.2018 Patentblatt 2018/09**

(21) Anmeldenummer: **12715051.4**

(22) Anmeldetag: **10.04.2012**

(51) Int Cl.:
*H01M 10/48* (2006.01)    *G06F 17/50* (2006.01)

(86) Internationale Anmeldenummer:
**PCT/EP2012/056405**

(87) Internationale Veröffentlichungsnummer:
**WO 2012/143253 (26.10.2012 Gazette 2012/43)**

(54) **VERFAHREN UND VORRICHTUNG ZUR ERMITTLUNG DER INNENTEMPERATUR EINES ENERGIESPEICHERS**

METHOD AND DEVICE FOR DETERMINING THE INTERNAL TEMPERATURE OF AN ENERGY STORE

PROCÉDÉ ET DISPOSITIF POUR DÉTERMINER LA TEMPÉRATURE INTERNE D'UN ACCUMULATEUR D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.04.2011 DE 102011007840**

(43) Veröffentlichungstag der Anmeldung:
**26.02.2014 Patentblatt 2014/09**

(73) Patentinhaber: **Bayerische Motoren Werke Aktiengesellschaft
80809 München (DE)**

(72) Erfinder:
• **FLECKENSTEIN, Matthias
84424 Isen (DE)**
• **FENKART, Marcel
80939 München (DE)**
• **BOHLEN, Oliver
80687 München (DE)**

(56) Entgegenhaltungen:
WO-A1-97/34133    WO-A2-98/22830
DE-A1-102007 049 707    DE-A1-102009 037 088
US-A- 6 076 964

• **DOUGHTY D H ET AL: "Lithium battery thermal models", JOURNAL OF POWER SOURCES, ELSEVIER SA, CH, Bd. 110, Nr. 2, 22. August 2002 (2002-08-22), Seiten 357-363, XP004393634, ISSN: 0378-7753, DOI: 10.1016/S0378-7753(02)00198-2**

**Beschreibung**

Die Erfindung betrifft ein Verfahren und eine Vorrichtung zur Ermittlung der Innentemperatur eines elektro-chemischen Energiespeichers, insbesondere für ein Kraftfahrzeug.

Die Leistungsfähigkeit eines elektro-chemischen Energiespeichers hängt von dessen Betriebstemperatur ab. Dies gilt insbesondere, aber nicht nur, für solche Energiespeicher, welche Lithium-Ionen-Speicherzellen verwenden. Ein im Umfeld von Kraftfahrzeugen eingesetzter Energiespeicher umfasst typischerweise eine Vielzahl an Speicherzellen, die seriell und/oder parallel elektrisch miteinander verschaltet sind, um eine vorgegebene Ausgangsspannung und einen vorgegebenen Ausgangsstrom bereitstellen zu können. In den zur Zeit entwickelten Speichermodulen basieren die Speicherzellen auf der eingangs erwähnten Lithium-Ionen-Technologie. Diese werden idealerweise in einem definierten Temperaturbereich betrieben. Dieser kann beispielsweise zwischen den Temperaturen +5 °C und +40 °C definiert werden. Übersteigt die Betriebstemperatur der Speicherzellen die obere Temperaturgrenze, so ergibt sich eine beschleunigte Alterung, so dass häufig eine geforderte Lebensdauer nicht eingehalten werden kann. Werden die Speicherzellen hingegen unterhalb der unteren Temperaturgrenze betrieben, so reduziert sich die Leistungsfähigkeit der Zelle stark. Zusätzlich können die Speicherzellen in diesem Temperaturbereich nur ineffizient betrieben werden. Beim Einsatz von Energiespeichern im Umfeld von Kraftfahrzeugen werden diese deshalb temperiert.

Um die Temperierung der Speicherzellen exakt und effizient vornehmen zu können, ist eine möglichst präzise Kenntnis der Ist-Temperatur, d.h. der Innentemperatur der Speicherzellen erforderlich. Basierend auf der ermittelten Ist-Temperatur der Speicherzellen kann dann die Temperaturregelung zum Kühlen oder Heizen der Speicherzellen erfolgen. Die Erfassung der Temperatur des Energiespeichers erfolgt zumeist über einen Temperatursensor an der Gehäuseoberfläche des Energiespeichers oder einer einzelnen Speicherzelle. Der hier gemessene Temperaturwert entspricht jedoch nicht der tatsächlichen Innentemperatur des elektro-chemischen Energiespeichers. Hierfür wäre die direkte Messung der Innentemperatur eines Zellwickels einer der Speicherzellen erforderlich. Eine Messung der Innentemperatur einer Speicherzelle ist jedoch mit einem großen konstruktiven Aufwand verbunden. Zum einen würde der Herstellungsprozess des Energiespeichers aufwendiger, z.B. aufgrund der Kabelführung für den Temperatursensor. Zum anderen müssen weitere Maßnahmen getroffen werden, um die Ansprüche an die Dichtigkeit einer betreffenden Speicherzelle bzw. des Energiespeichers im Gesamten zu erfüllen.

Der Stand der Technik wird beispielsweise in WO 97/34133 A1 offenbart. Es ist Aufgabe der vorliegenden Erfindung, ein Verfahren und eine Vorrichtung anzugeben, mit denen die Ermittlung der Innentemperatur eines elektro-chemischen Energiespeichers auf einfachere Weise möglich ist.

Diese Aufgaben werden gelöst durch ein Verfahren gemäß den Merkmalen des Patentanspruches 1 und einen elektro-chemischen Energiespeicher gemäß den Merkmalen des Patentanspruches 8. Vorteilhafte Ausgestaltungen ergeben sich aus den abhängigen Patentansprüchen.

Die Erfindung schafft ein Verfahren zur Ermittlung der Innentemperatur eines elektro-chemischen Energiespeichers, insbesondere für ein Kraftfahrzeug, bei dem in einem Steuergerät des Energiespeichers mittels eines in diesem hinterlegten thermischen Modell für den elektrischen Energiespeicher rechnergestützt die Innentemperatur eines Zellwickels des elektrischen Energiespeichers ermittelt wird.

Die Erfindung schafft weiter einen elektro-chemischen Energiespeicher, insbesondere für ein Kraftfahrzeug, mit einem Steuergerät, in dem ein thermisches Modell des elektrischen Energiespeichers hinterlegt ist, wobei der Energiespeicher dazu ausgebildet ist, das erfindungsgemäße Verfahren auszuführen.

Durch die Erfindung kann auf einen Temperatursensor zur direkten Messung der Innentemperatur des elektro-chemischen Energiespeichers verzichtet werden, was der konstruktiven Gestaltung des Energiespeichers zu Gute kommt. Durch die Simulation der Innentemperatur unter Verwendung eines thermischen Modells für den Energiespeicher kann andererseits eine genauest mögliche Temperierung der Speicherzellen des Energiespeichers realisiert werden. Ein zeitlich homogenerer und wärmerer Betrieb des Energiespeichers durch eine präzisere Temperaturregelung führt zu einem insgesamt effizienteren Betrieb des Energiespeichers, ohne der Gefahr einer Schädigung von Speicherzellen des Energiespeichers. Ebenso ist die Gefahr minimiert, solche Temperaturgrenzen von Speicherzellen des Energiespeichers zu überschreiten, welche zu einer schnelleren Alterung führen. Ein weiterer Vorteil der simulierten Innentemperatur des Energiespeichers besteht darin, dass ein genaueres Temperatursignal als Eingangssignal für weitere Aspekte einer Zustandserkennung, wie bspw. einer Ladezustandserkennung, verwendet werden kann. Hierdurch steigt auch die Genauigkeit weiterer Zustandsschätzungen.

Zweckmäßigerweise wird das thermische Modell des Energiespeichers aus thermischen Kapazitäten und thermischen Widerständen gebildet. Dabei ist ein thermischer Widerstand zwischen zwei der thermischen Kapazitäten angeordnet. Die thermischen Kapazitäten repräsentieren Komponenten des Energiespeichers, wie z.B. den Zellwickel einer oder mehrerer Speicherzellen, das Gehäuse einer Speicherzelle , ein Anschlussterminal der Speicherzelle, eine Kühleinrichtung usw. Mittels des thermischen Widerstands zwischen zwei der thermischen Kapazitäten wird ein Maß für die Wärmeableitung von einer thermischen Kapazität zu der anderen thermischen Kapazität berücksichtigt.

Insbesondere sind in dem thermischen Modell die thermischen Kapazitäten für den Zellwickel zumindest einer Speicherzelle des Energiespeichers, für das Gehäuse der Speicherzelle(n), für zumindest ein Anschlussterminal der Speicherzelle(n), und optional, für die Kühleinrichtung berücksichtigt. Die Berücksichtigung der Kühleinrichtung als thermische Kapazität in dem thermischen Modell ist optional, da die Kühleinrichtung in Abhängigkeit der Regelung ein- oder ausgeschaltet sein kann. Ist die Kühleinrichtung nicht aktiv, so kann diese in dem thermischen Modell vernachlässigt werden. Lediglich dann, wenn die Kühleinrichtung in Betrieb ist, braucht deren thermische Kapazität berücksichtigt zu werden.

Es ist ferner zweckmäßig, wenn in dem thermischen Modell auch eine Verlustleistung des Energiespeichers verarbeitet wird, welche z.B. aus einem messtechnisch erfassten Strom in dem Energiespeicher ermittelt wird. Die Berücksichtigung der Verlustleistung des Energiespeichers ist dann von Bedeutung, wenn im Rahmen der Simulation die Temperatur des Zellwickels einer der Speicherzellen ermittelt wird, da diese durch die Verlustleistung beeinflusst wird.

Es ist weiter zweckmäßig, wenn zumindest die Temperatur einer Komponente des Energiespeichers, welche eine der thermischen Kapazitäten mit Ausnahme des Zellwickels repräsentiert, messtechnisch ermittelt und in dem thermischen Modell berücksichtigt wird.

Vorzugsweise wird eine einfach zu messende Temperatur berücksichtigt, z.B. die an der Gehäuseaußenseite vorherrschende Temperatur. Alternativ kann die an einem Anschlussterminal vorherrschende Temperatur, aber auch die Temperatur der Kühleinrichtung, messtechnisch erfasst werden.

Für das thermische Modell werden iterativ für einen vorgegebenen Zeitschritt ausgetauschte Wärmemengen zwischen zwei benachbarten thermischen Kapazitäten aus deren Temperaturdifferenz nach folgender Formel ermittelt:

$$Q_{i \to i+1} = \frac{T_i - T_{i+1}}{R_{th,i \to i+1}} \Delta t \quad (1)$$

Anschließend werden für das thermische Modell iterativ aus den ermittelten Wärmemengen die Temperaturen für die thermischen Kapazitäten für jeden vorgegebenen Zeitschritt nach folgender Formel ermittelt:

$$T_i(t_0 + \Delta t) = T_i(t_0) + \frac{1}{C_{th,i}} \sum_{k=1}^{n} Q_k \quad (2)$$

Das erfindungsgemäß vorgeschlagene Verfahren basiert somit auf der iterativen Bestimmung von Wärmeströmen für jede thermische Kapazität, aus denen dann die entsprechenden Temperaturen errechnet werden können. Da das erfindungsgemäße Verfahren "online", d.h. in Echtzeit, während des Betriebs des Steuergeräts des Energiespeichers ermittelt wird, müssen bei einem Neustart des Steuergeräts die in der Simulation verwendeten Startwerte zumindest mancher der Temperaturen zunächst initial festgelegt werden. Dabei ist zu unterscheiden, ob der Neustart des Steuergeräts innerhalb eines vorgegebenen Grenzwerts für die Stillstandszeit erfolgt oder ob der Neustart nach Verstreichen des vorgegebenen Grenzwerts der Stillstandszeit erfolgt. Im letzteren Fall kann davon ausgegangen werden, dass sämtliche Komponenten des Energiespeichers den gleichen Temperaturwert aufweisen. Somit kann anhand der nach dem Start des Steuergeräts festgestellten Messung des zumindest einen Temperaturwerts dieser auch für die Temperaturwerte der anderen Komponenten verwendet werden. Alternativ kann die Initialbedingung als kontinuierliche Funktion der Stillstandszeit z.B. in Form einer Abklingkurve berechnet werden.

Wurde der vorgegebene Wert für die Stillstandszeit bei dem Neustart des Steuergeräts und damit der Wiederinbetriebnahme des Energiespeichers noch nicht erreicht, so weisen die Komponenten des Energiespeichers unterschiedliche Temperaturwerte auf. In diesem Fall ist es zweckmäßig, wenn nach einer Stillstandsphase bis zu einer vorgegebenen maximalen Zeitdauer des Energiespeichers Temperatur-Startwerte für die messtechnisch nicht erfassbaren oder messtechnisch nicht erfassten Temperaturen der Komponenten, welche thermische Kapazitäten repräsentieren, für die Anwendung des thermischen Modells rechnergestützt abgeschätzt werden. Hierdurch kann ein Startwert--Fehler der ermittelten Temperatur nach jeder Standphase minimiert werden.

Die Minimierung des Offset-Fehlers kann dabei vor der in Echtzeit durchgeführten Simulation mathematisch abgeschätzt werden. Für die Abschätzung eines Temperatur-Startwertes nach der Stillstandsphase können in einer ersten Variante nachfolgende Schritte durchgeführt werden. Zunächst werden der betreffende, zuletzt vor der Stillstandsphase rechnergestützt ermittelte Temperaturwert und ein gemessener Temperaturwert an einer anderen Komponente der Speicherzelle abgespeichert. Am Ende der Stillstandsphase wird eine Temperaturdifferenz zwischen dem abgespeicherten gemessenen Temperaturwert und dem rechnergestützt ermittelten Temperaturwert errechnet, wobei der rechnergestützt ermittelte Temperaturwert vor der Bildung der Temperaturdifferenz mittels einer vorgegebenen Abklingkurve und der Länge der Stillstandsphase korrigiert wird. Die Temperaturdifferenz wird auf den am Ende der Stillstandsphase gemessenen Temperaturwert aufaddiert, wobei der sich hieraus ergebende Summenwert den Temperatur-Standwert ergibt.

Zusätzlich kann für die schnellstmögliche Korrektur des verbleibenden Startwertfehlers in der Anfangsphase jeder Simulation und auch zur Minimierung der Abweichung zwischen Simulation und Realität während der gesamten Simulationszeit ein regelungstechnischer Beobachter eingesetzt werden. Mit Hilfe des regelungstechnischen Beobachters kann vorteilhaft gleichzeitig eine gemessene Oberflächentemperatur in dem thermischen Modell mitgerechnet werden. Beispielsweise kann dies für die Stromabgriffstemperatur bei einer gegebenen Temperatur der Kühleinrichtung erfolgen.

Die Erfindung wird nachfolgend näher anhand eines Ausführungsbeispiels in der Zeichnung erläutert. Es zeigen:

Fig. 1    ein thermisches Ersatzschaltbild eines vereinfachten elektro-chemischen Energiespeichers, insbesondere für den Einsatz in einem Kraftfahrzeug,

Fig. 2    ein Temperatur-Zeit-Diagramm, anhand dem das Vorgehen zur Ermittlung von Simulationsstartwerten für messtechnisch nicht erfasste Temperaturkomponenten nach einer Stillstandsphase erläutert wird, und

Fig. 3    eine schematische Darstellung eines regelungstechnischen Beobachters zur Minimierung von Fehlerabweichungen in dem thermischen Modells des Energiespeichers gemäß Fig. 1.

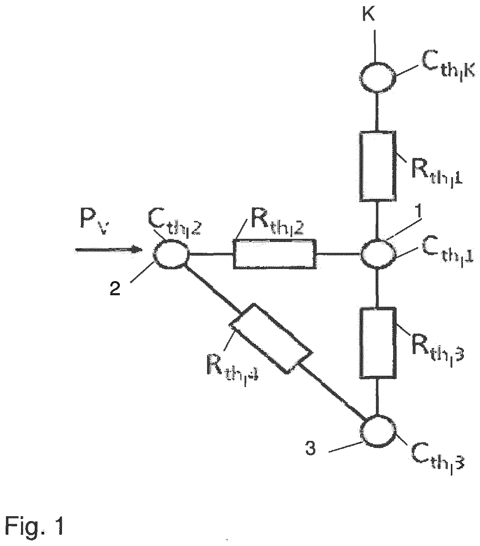

Fig. 1 zeigt ein thermisches Ersatzschaltbild für einen elektro-chemischen Energiespeicher, wie er bspw. in einem elektrisch betriebenen Kraftfahrzeug zum Einsatz kommen kann. Ein solcher Energiespeicher umfasst bspw. eine Mehrzahl an hintereinander angeordneten, prismatischen Speicherzellen. Prinzipiell könnte der elektro-chemische Energiespeicher auch aus einer Vielzahl an zylindrischen Speicherzellen gebildet sein. Jede der Speicherzellen weist zwei Anschlussterminals auf. Das erste Anschlussterminal stellt bspw. den Plus-Pol, das zweite Anschlussterminal den Minus-Pol der Speicherzelle dar. Üblicherweise ist der Plus-Pol elektrisch mit dem Gehäuse der Speicherzelle verbunden. Die Speicherzellen sind derart hintereinander angeordnet, dass benachbart zu einem ersten Anschlussterminal einer Speicherzelle das zweite Anschlussterminal der benachbarten Speicherzelle zum Liegen kommt. Dadurch, dass jeweils zwei benachbarte zueinander angeordnete Anschlussterminals nebeneinander angeordnet sind, kann unter Verwendung von Anschlusselementen eine serielle Verschaltung der Speicherzellen erfolgen. Es ist auch möglich, dass bei benachbart zueinander angeordnete gleiche Anschlussterminals nebeneinander angeordnet sind, um benachbarte Speicherzellen parallel zu verschalten. Damit können von dem Energiespeicher höhere Ströme bereitgestellt werden.

Die Gesamtheit an Speicherzellen ist üblicherweise in einem Gehäuse angeordnet. Typischerweise am Boden des Gehäuses ist eine Kühl- und Heizvorrichtung angeordnet, welche in das Gehäuse integriert sein kann, um die Speicherzellen beim Betrieb des Energiespeichers in einem vorgeschriebenen Temperaturbereich zu halten.

Speicherzellen eines Energiespeichers für die Verwendung in einem Kraftfahrzeug basieren derzeit üblicherweise auf der Lithium-Ionen-Technologie. Derartige Speicherzellen sind in einem definierten Temperaturbereich zu betreiben. Dieser kann beispielsweise zwischen +5 °C bis +40 °C definiert sein. Temperaturen oberhalb von +40 °C können zu einer reduzierten Lebensdauer der Zellen führen. Ein Betrieb bei Temperaturen unterhalb von +5 °C führt zu einer verminderten Leistungsfähigkeit und einer geringeren Effizienz der jeweiligen Speicherzelle im Betrieb. Diese Problematik gilt - mit eventuell anderen Temperaturgrenzen - auch für andere Typen von Speicherzellen. Je präziser die tatsächliche Temperatur im Inneren einer jeweiligen Speicherzelle ermittelt wird, desto präziser kann die Kühlung bzw. Heizung der Speicherzellen des Energiespeichers erfolgen.

Erfindungsgemäß wird anstelle einer tatsächlichen Messung die Innentemperatur des Energiespeichers durch Simulation unter Verwendung eines in einem Steuergerät des Energiespeichers hinterlegten thermischen Modells rechnergestützt ermittelt. In der vorliegenden Beschreibung ist unter der Innentemperatur dabei die im Inneren einer Speicherzelle auftretende Temperatur zu verstehen, welche der Temperatur des sog. Zellwickels, in dem die elektro-chemischen Vorgänge der Speicherzelle stattfinden, entspricht.

Hierzu wird ein thermisches Modell des Energiespeichers verwendet, welches thermische Kapazitäten $C_{th,i}$, wobei $i = 1$ bis $k$ ist, und thermische Widerstände $R_{th,j}$, wobei $j = 1$ bis 4 ist, umfasst. In dem in Fig. 1 dargestellten vereinfachten thermischen Modell sind thermische Kapazitäten $C_{th,1}$, $C_{th,2}$, $C_{th,3}$ und $C_{th,k}$ für das Gehäuse 1 einer Energiespeicherzelle, den Zellwickel 2 einer der Speicherzellen des Energiespeichers, ein Zell- bzw. Anschlussterminal 3 einer Speicherzelle und eine optionale Kühleinrichtung K berücksichtigt. Entsprechend den in dem Energiespeicher möglichen Wärmepfaden sind die thermischen Widerstände $R_{th,1}$, $R_{th,2}$, $R_{th,3}$ und $R_{th,4}$ zwischen jeweils zwei der thermischen Kapazitäten angeordnet. Der Widerstand $R_{th,1}$ stellt den thermischen Widerstand zwischen der Kühleinrichtung und dem Gehäuse 1 dar. $R_{th,2}$ repräsentiert den thermischen Widerstand zwischen dem Gehäuse 1 und dem Zellwickel 2. $R_{th,3}$ repräsentiert den thermischen Widerstand zwischen dem Gehäuse 1 und dem Zellterminal 3. $R_{th,4}$ repräsentiert den thermischen Widerstand zwischen dem Zellwickel 2 und dem Zell- bzw. Anschlussterminal 3. Im Betrieb des Energiespeichers stellen sich an den die thermischen Kapazitäten repräsentierenden Komponenten 1, 2, 3, K Temperaturen $T_1$, $T_2$, $T_3$ und $T_k$ ein.

Eine Berücksichtigung der thermischen Kapazität $C_{th,k}$ der Kühlvorrichtung K und des zugeordneten thermischen Widerstandes Rth,1 kann in Abhängigkeit davon erfolgen, ob die Kühleinrichtung betrieben wird oder nicht. Wird die Kühleinrichtung nicht aktiv zur Temperierung des Energiespeichers betrieben, so können die genannten Komponenten vernachlässigt werden. Lediglich bei aktivierter Kühleinrichtung ist die Berücksichtigung der genannten Komponenten zweckmäßig.

In dem thermischen Modell wird weiterhin eine Verlustleistung PV des Energiespeichers berücksichtigt. Diese kann bspw. indirekt aus einem messtechnisch erfassten Strom in dem Energiespeicher ermittelt werden.

Zur Simulation der Innentemperatur des Energiespeichers ist es zweckmäßig, wenn wenigstens eine der Temperaturen T1, T3, Tk des Gehäuses 1, des Zell- bzw. Anschlussterminals 3 oder der Kühlvorrichtung K ermittelt wird. Hierdurch kann die Innentemperatur des Energiespeichers in kurzer Zeit korrekt bestimmt werden. Prinzipiell könnte jedoch auch auf eine derartige messtechnische Bereitstellung eines Temperatursignals verzichtet werden. Allerdings würde dann die korrekte Ermittlung der Innentemperatur des Energiespeichers eine sehr viel größere Zeit in Anspruch nehmen.

Die Innentemperatur des Energiespeichers wird "online", d.h. in Echtzeit, rechnergestützt in dem dem Energiespeicher zugeordneten Steuergerät ermittelt. Hierzu werden iterativ für jeden Zeitschritt $\Delta t$ die ausgetauschte Wärmemenge Q zwischen zwei benachbarten thermischen Kapazitäten Cth, i und Cth, i+1 aus deren Temperaturdifferenz Ti-Ti+1 bestimmt. Da der Wärmestrom $Q/\Delta t$ von einer thermischen Kapazität i zu einer thermischen Kapazität i+1 während eines Zeitschritts als konstant angenommen werden kann, bestimmt sich die ausgetauschte Wärmemenge während eines Zeitschritts gemäß Gleichung (1) zu

$$Q_{i \rightarrow i+1} = \frac{T_i - T_{i+1}}{R_{th,i \rightarrow i+1}} \Delta t. \qquad (1)$$

Die Temperatur an der thermischen Kapazität Cth,i lässt sich anschließend explizit für jeden Zeitschritt mit Hilfe der Wärmestrombilanz gemäß Gleichung (2)

$$T_i(t_0 + \Delta t) = T_i(t_0) + \frac{1}{C_{th,i}} \sum_{k=1}^{n} Q_k \qquad (2)$$

ermitteln. Mit anderen Worten bedeutet dies, dass für jede der durch eine thermische Kapazität repräsentierten Komponenten 1, 2, 3, K eine Wärmemengenbilanz aufgestellt wird, bei der von der thermischen Kapazität abgehende Wärmemenge und in die betreffende thermische Kapazität fließende Wärmemenge aufaddiert werden. Die Wärmemengen können anhand der Temperaturunterschiede zu den jeweils benachbarten thermischen Kapazitäten ermittelt werden. Obwohl für die Durchführung der Regelung einer Kühlung bzw. Heizung des Energiespeichers lediglich die Innentemperatur der Energiespeicherzellen von Interesse ist, werden für die Ermittlung dieser Temperatur auch die Temperaturen der benachbarten thermischen Kapazitäten benötigt, so dass diese wahlweise durch Simulation ermittelt und/oder messtechnisch erfasst werden.

Um in der Simulation einen Startwert-Fehler der rechnergestützt ermittelten Temperatur(en) der Komponenten nach jeder Stillstandsphase des Energiespeichers möglichst gering zu halten, ist weiter vorgesehen, die für die Simulation verwendeten Temperatur-Startwerte vor der Durchführung der iterativen Simulation mathematisch abzuschätzen. Dies ist insbesondere dann von Bedeutung, wenn die Stillstandsdauer unterhalb eines vorgegebenen Schwellwerts liegt, welcher abhängig von dem Typ und der Geometrie des Energiespeichers ist. Der Schwellwert für die Stillstandsphase ist bei prismatischen Speicherzellen je nach Zellgröße in etwa zwischen 1 und 3 Stunden. Umfasst der Energiespeicher zylindrische Speicherzellen, so liegt der Grenzwert je nach Zellgröße für die Stillstandsphase zwischen 0,5 und 2 Stunden. Die mathematische Abschätzung der Temperatur-Startwerte erfolgt lediglich dann, wenn die Stillstandsphase geringer als der für den Energiespeicher vorgegebene Grenzwert ist. Bei einer über den Grenzwert hinausgehenden Stillstandsphase kann davon ausgegangen werden, dass sich die an den relevanten Komponenten vorherrschenden Temperaturen aneinander angeglichen haben. Somit kann als Startwert, der durch eine Messung ermittelte Temperaturwert bspw. des Zellterminals 3 verwendet werden.

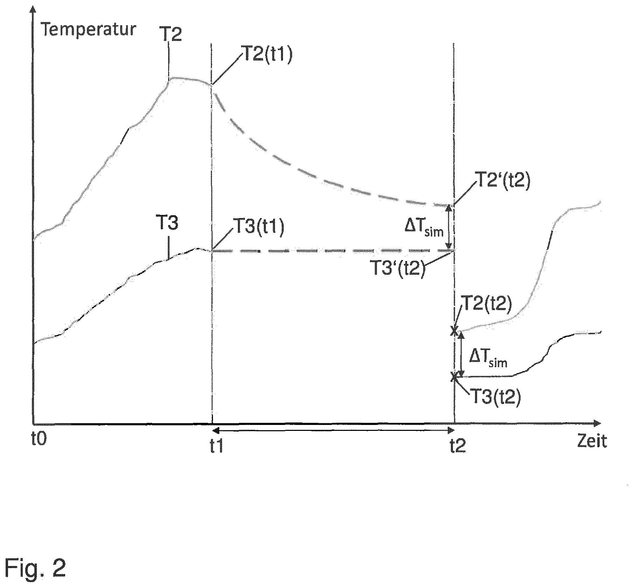

Ist die Stillstandsphase hingegen kleiner als der vorgegebene Grenzwert, so erfolgt eine wie nachfolgend beschriebene Abschätzung des Temperatur-Startwertes. Das Prinzip ist dabei schematisch in Fig. 2 dargestellt. Fig. 2 zeigt ein Temperatur-Zeit-Diagramm. In diesem sind die Temperaturverläufe für den Zellwickel (T2) und das Zell- bzw. Anschlussterminal (T3) über die Zeit dargestellt. Zwischen t0 und t1 ist der Energiespeicher in Betrieb, wobei der Temperaturwert T3 gemessen und der Temperaturwert T2 des Zellwickels über das thermische Modell simuliert ist. Zum Zeitpunkt t1 beginnt eine Stillstandsphase (Standphase), d.h. es erfolgt keine Energieentnahme aus dem Energiespeicher und keine Einspeisung in den Energiespeicher. Die Stillstandsphase dauert bis zum Zeitpunkt t2. Zur Minimierung eines Startwert-Fehlers der ermittelten Temperatur in der Simulation wird zunächst zum Beginn der Stillstandsphase, d.h. zum Zeitpunkt t1 der gemessene Temperaturwert T3 (t1) sowie der rechentechnisch ermittelte Temperaturwert T2 (t1) in dem Steuergerät abgespeichert. Am Ende der Stillstandsphase, d.h. zum Zeitpunkt t2, wird der Energiespeicher wieder in Betrieb genommen.

Hierbei wird durch das Steuergerät zunächst die Länge der Stillstandsphase, d.h. t2-t1, ermittelt. Mit Hilfe von in dem Steuergerät hinterlegten Abklingkurven für den Zellwickel T2 kann eine Temperaturdifferenz ΔTsim zu der Referenztemperatur T3 (t1) ermittelt werden. Die Abklingkurve ist in guter Annäherung eine Exponentialfunktion mit angepasster Zeitkonstante. Aus der Abklingkurve und der Länge der Stillstandsphase kann die Innentemperatur des Zellwickels T2' (t2) zum Zeitpunkt t2 errechnet werden. Die Differenz zur abgespeicherten Temperatur des Zellterminals T3' (t2) ergibt die gesuchte Temperaturdifferenz ΔTsim. Dabei wird davon ausgegangen, dass T3' (t2) der abgespeicherten Temperatur T3 (t1) zum Zeitpunkt t1 entspricht. Die errechnete Temperaturdifferenz ΔTsim wird anschließend auf den ersten Messwert am Zellterminal T3 (t2) addiert. Hieraus ergibt sich der Temperatur-Startwert T2 (t2) zum Zeitpunkt t2.

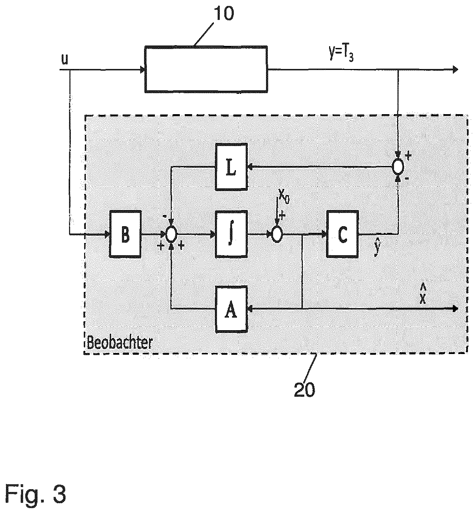

Um zusätzlich nach der Stillstandsphase eine schnellstmögliche Korrektur des verbleibenden Startwertfehlers durchzuführen und auch um die Abweichung zwischen Simulation und Realität während der gesamten Simulationszeit zu minimieren kann ein regelungstechnischer Beobachter verwendet werden. Ein solcher Beobachter 20 ist in Verbindung mit einem Energiespeicher 10 in Fig. 3 dargestellt. Der Beobachter 20 ist als Luenberger-Beobachter aufgebaut, welcher aus dem Stand der Technik bekannt ist. Bei Verwendung eines Beobachters zur Minimierung eines Startwert- oder Offset-Fehlers kann die gemessene Temperatur, bspw. am Zellterminal, im Beobachtermodell zeitgleich mitgerechnet werden. Hierdurch kann die Simulation an den Messwert angepasst werden.

Die Beschreibung des thermischen Modells durch Differentialgleichungen gemäß den Gleichungen (1) und (2) kann in den Zustandsraum überführt werden. Der letzte Term der rechten Seite von Gleichung (3) und (4) gibt die Rückführung des Temperatur-Messsignals vom Zellterminal in die Simulation wieder

$$\dot{x} = A \cdot x + B \cdot u + L(y - \hat{y}) \quad (3)$$

$$\begin{pmatrix} \dot{T}_1 \\ \dot{T}_2 \\ \dot{T}_3 \end{pmatrix} = \begin{pmatrix} -\dfrac{1}{C_1 R_1} - \dfrac{1}{C_1 R_2} - \dfrac{1}{C_1 R_3} & \dfrac{1}{C_1 R_2} & \dfrac{1}{C_1 R_3} \\ \dfrac{1}{C_2 R_2} & -\dfrac{1}{C_2 R_2} - \dfrac{1}{C_2 R_4} & \dfrac{1}{C_2 R_4} \\ \dfrac{1}{C_3 R_3} & \dfrac{1}{C_3 R_4} & -\dfrac{1}{C_3 R_3} - \dfrac{1}{C_3 R_4} \end{pmatrix} \cdot \begin{pmatrix} T_1 \\ T_2 \\ T_3 \end{pmatrix} + \begin{pmatrix} 0 & \dfrac{1}{C_1 R_1} \\ \dfrac{1}{C_2} & 0 \\ 0 & 0 \end{pmatrix} \cdot \begin{pmatrix} P_v \\ T_K \end{pmatrix} + \begin{pmatrix} l_1 \\ l_2 \\ l_3 \end{pmatrix} \cdot (y - \hat{y})$$

$$(4)$$

$$y = C \cdot x \quad (5)$$

$$y = \begin{pmatrix} 0 & 0 & 1 \end{pmatrix} \cdot \begin{pmatrix} T_1 \\ T_2 \\ T_3 \end{pmatrix} \quad (6).$$

Gleichung (3), (4), (5) und (6) repräsentieren die Zustandsraumdarstellung des thermischen Modells in Kombination mit einem Luenberger-Beobachter entsprechend Fig. 3 in einer dem Fachmann bekannten Weise . Das thermische Modell wird somit in dem Steuergerät mitsimuliert.

Abweichungen zwischen Simulation und gemessenen Temperaturwerten können mit einer Korrekturmatrix L multipliziert und in das thermische Modell zurückgeführt werden. Der Beobachter 20 kann damit auf Ungenauigkeiten des Modells und der Startwertermittlung reagieren. Der Temperatur-Startwert wird in den Beobachter bei $x_0$ eingespeist.

**Bezugszeichenliste**

1 Gehäuse
2 Zellterminal

| | |
|---|---|
| 3 | Zellwickel |
| K | Kühleinrichtung |
| 10 | Energiespeicher |
| 20 | Beobachter |
| T1 | Temperatur des Gehäuses |
| T2 | Temperatur des Zellterminals |
| T3 | Temperatur des Zellwickels |
| TK | Temperatur der Kühleinrichtung |
| T2(t1) | Temperatur des Zellterminals zum Zeitpunkt t1 |
| T3(t1) | Temperatur des Zellwickels zum Zeitpunkt t1 |
| T2'(t2) | zum Zeitpunkt t1 gespeicherte Temperatur des Zellterminals zum Zeitpunkt t2 |
| T3'(t2) | errechnete Temperatur des Zellwickels zum Zeitpunkt t2 |
| T2(t2) | Temperatur-Startwert des Zellterminals zum Zeitpunkt t2 |
| T3(t2) | gemessene Temperatur des Zellwickels zum Zeitpunkt t2 |
| PV | Verlustleistung |
| Cth,1 | thermische Kapazität des Gehäuses |
| Cth,2 | thermische Kapazität des Zellterminals |
| Cth,3 | thermische Kapazität des Zellwickels |
| Cth,K | thermische Kapazität der Kühleinrichtung |
| Rth,1 | thermischer Widerstand des Gehäuses |
| Rth,2 | thermischer Widerstand des Zellterminals |
| Rth,3 | thermischer Widerstand des Zellwickels |
| Rth,K | thermischer Widerstand der Kühleinrichtung |
| T | Temperatur |
| t | Zeit |

**Patentansprüche**

1. Verfahren zur Ermittlung der Innentemperatur eines elektro-chemischen Energiespeichers (10), insbesondere für ein Kraftfahrzeug, bei dem in einem Steuergerät des Energiespeichers (10) mittels eines in diesem hinterlegten thermischen Modells für den Energiespeicher (10) rechnergestützt die Innentemperatur eines Zellwickels (3) des elektrischen Energiespeichers (10) ermittelt wird,
bei dem das thermische Modell des Energiespeichers (10) aus thermischen Kapazitäten ($C_{th,i}$, wobei i = 1 bis k) und thermischen Widerständen ($R_{th,j}$, wobei j = 1 bis 4) gebildet wird, wobei ein thermischer Widerstand ($R_{th,j}$) zwischen zwei der thermischen Kapazitäten ($C_{th,i}$) angeordnet ist, **gekennzeichnet dadurch, dass** nach einer Stillstandsphase bis zu einer vorgegebenen maximalen Zeitdauer des Energiespeichers (10) Temperatur-Startwerte ($T_i$, wobei i = 1 bis k) für die messtechnisch nicht erfassbaren oder messtechnisch nicht erfassten Temperaturen der Komponenten, welche thermische Kapazitäten ($C_{th,i}$) repräsentieren, für die Anwendung des thermischen Modells rechnergestützt abgeschätzt werden, und wobei für die Abschätzung eines Temperatur-Startwertes ($T_i$) nach der Stillstandsphase
der betreffende, zuletzt vor der Stillstandsphase rechnergestützt ermittelte Temperaturwert und ein gemessener Temperaturwert abgespeichert werden,
am Ende der Stillstandsphase eine Temperaturdifferenz zwischen dem abgespeicherten gemessenen Temperaturwert und dem rechnergestützt ermittelten Temperaturwert errechnet wird, wobei der rechnergestützt ermittelte Temperaturwert vor der Bildung der Temperaturdifferenz mittels einer vorgegebenen Abklingkurve und der Länge der Stillstandsphase korrigiert wird
und die Temperaturdifferenz auf den am Ende der Stillstandsphase gemessenen Temperaturwert aufaddiert wird, wobei der sich hieraus ergebende Summenwert den Temperatur-Startwert ($T_i$) ergibt.

2. Verfahren nach Anspruch 1, bei dem in dem thermischen Modell die thermischen Kapazitäten ($C_{th,i}$) für den Zellwickel (2) zumindest einer Speicherzelle des Energiespeichers (10), für das Gehäuse (1) dieser Speicherzelle(n) (10), für zumindest ein Anschlussterminal (3) der Speicherzelle(n), und optional, für eine Kühleinrichtung (K) berücksichtigt sind.

3. Verfahren nach einem der vorhergehenden Ansprüche, bei dem in dem thermischen Modell eine Verlustleistung des Energiespeichers (10) verarbeitet wird, welche aus einem messtechnisch erfassten Strom in dem Energiespeicher (10) ermittelt wird.

**4.** Verfahren nach einem der vorhergehenden Ansprüche, bei dem zumindest die Temperatur einer Komponente des Energiespeichers (10), welche eine der thermischen Kapazitäten (Cth,i) mit Ausnahme des Zellwickels repräsentiert, messtechnisch ermittelt und in dem thermischen Modell berücksichtigt wird.

**5.** Verfahren nach einem der vorhergehenden Ansprüche, bei dem für das thermische Modell iterativ für einen vorgegebenen Zeitschritt ($\Delta t$) die ausgetauschte Wärmemenge ($Q_{i \to i+1}$) zwischen zwei benachbarten thermischen Kapazitäten (Cth,i) aus deren Temperaturdifferenz ($T_i - T_{i+1}$) nach folgender Formel ermittelt werden mit dem thermischen Widerstand des Zeitschritts ($R_{th,i \to i+1}$):

$$Q_{i \to i+1} = \frac{T_i - T_{i+1}}{R_{th,i \to i+1}} \Delta t$$

**6.** Verfahren nach Anspruch 5, bei dem für das thermische Modell iterativ aus den ermittelten ausgetauschten Wärmemengen ($Q_k$) die Temperaturen ($T_i (t_0 + \Delta t)$) für die thermischen Kapazitäten ($C_{th,i}$) für jeden vorgegebenen Zeitschritt (i) nach folgender Formel ermittelt werden mit dem vorgegebenen Zeitschritt ($\Delta t$):

$$T_i\left(t_0 + \Delta t\right) = T_i\left(t_0\right) + \frac{1}{C_{th,i}} \sum\nolimits_{k=1}^{n} Q_k$$

**7.** Verfahren nach einem der vorhergehenden Ansprüche, bei dem in der Simulation für die Fehlerkorrektur eines Temperatur-Startwertes (Ti) nach der Stillstandsphase ein regelungstechnischer Beobachter (20) eingesetzt wird.

**8.** Elektro-chemischer Energiespeicher (10), insbesondere für ein Kraftfahrzeug, mit einem Steuergerät, in dem ein thermisches Modell des Energiespeichers (10) hinterlegt ist, wobei dieser dazu ausgebildet ist, das Verfahren nach einem der vorhergehenden Ansprüche auszuführen.

**Claims**

**1.** A method for determining the internal temperature of an electrochemical energy storage device (10), more especially for a motor vehicle, in which the internal temperature of a cell winding (3) of the electrical energy storage device (10) is determined in a control device of the energy storage device (10), in a computer-aided manner, by means of a thermal model for the energy storage device (10) stored in the control device, in which the thermal model of the energy storage device (10) is formed from thermal capacitances (Cth,i, wherein i = 1 to k) and thermal resistances (Rth,j, wherein j = 1 to 4), wherein a thermal resistance (Rth,j) is arranged between two of the thermal capacitances (Cth,i), **characterised in that,** after a downtime phase up to a predefined maximum time period of the energy storage device (10), starting temperature values (Ti, wherein i = 1 to k) are estimated in a computer-aided manner for the temperatures of the components which represent thermal capacitances (Cth,i), which temperatures cannot be detected by measurement or are not detected by measurement, for use in the thermal model, and wherein, for the estimation of a starting temperature value (Ti) following the downtime phase, the relevant temperature value last determined in a computer-aided manner prior to the downtime phase, as well as a measured temperature value, are saved, at the end of the downtime phase, a temperature difference between the saved, measured temperature value and the temperature value determined in a computer-aided manner is calculated, wherein the temperature value determined in a computer-aided manner is corrected prior to the temperature difference being formed, by means of a predefined decay curve and the duration of the downtime phase, and the temperature difference is added to the temperature value measured at the end of the downtime phase, wherein the resulting sum gives the starting temperature value (Ti).

**2.** A method according to claim 1, in which the thermal capacitances (Cth,i) for the cell winding (2) of at least one storage cell of the energy storage device (10), for the housing (1) of this/these storage cell(s) (10), for at least one connection terminal (3) of the storage cell(s), and optionally for a cooling device (K) are taken into consideration in the thermal model.

**3.** A method according to any one of the preceding claims, in which a dissipation loss of the energy storage device (10) is processed in the thermal model and is determined from a current in the energy storage device (10) detected by measurement.

4. A method according to any one of the preceding claims, in which at least the temperature of a component of the energy storage device (10) which represents one of the thermal capacitances (Cth,i) with the exception of the cell winding is determined by measurement and is taken into consideration in the thermal model.

5. A method according to any one of the preceding claims, in which the heat volume ($Q_{i->i+1}$) exchanged between two adjacent thermal capacitances (Cth,i) is determined iteratively for the thermal model from a temperature difference ($T_i$-$T_{i+1}$) between said thermal capacitances, for a predefined time interval ($\Delta t$), in accordance with the following formula with the thermal resistance of the time interval ($R_{th,i->i+1}$):

$$Q_{i \rightarrow i+1} = \frac{T_i - T_{i+1}}{R_{th,i \rightarrow i+1}} \Delta t$$

6. A method according to claim 5, in which the temperatures ($T_i$ ($t_0+\Delta t$)) for the thermal capacitances ($C_{th,i}$) for each predefined time interval (i) are determined iteratively for the thermal model from the determined exchanged heat volumes ($Q_k$) in accordance with the following formula with the predefined time interval ($\Delta t$):

$$T_i(t_0 + \Delta t) = T_i(t_0) + \frac{1}{C_{th,i}} \sum_{k=1}^{n} Q_k$$

7. A method according to any one of the preceding claims, in which a regulatory observer (20) is used in the simulation for the fault correction of a starting temperature value (Ti) following the downtime phase.

8. An electrochemical energy storage device (10), more especially for a motor vehicle, with a control device, in which a thermal model of the energy storage device (10) is stored, wherein this control device is designed to carry out the method according to any one of the preceding claims.

**Revendications**

1. Procédé permettant de déterminer la température interne d'un accumulateur d'énergie électrochimique (10), en particulier d'un véhicule selon lequel on détermine de façon assistée par ordinateur dans un appareil de commande de l'accumulateur d'énergie (10), au moyen d'un modèle thermique de cet accumulateur d'énergie (10) déposé dans cet appareil, la température interne d'un enroulement cellulaire (3) de l'accumulateur d'énergie (10) électrique, le modèle thermique de l'accumulateur d'énergie (10) est formé à partir de capacités thermiques (Cth,i = 1 à k) et de résistances thermiques (Rth,j = 1 à 4), et une résistance thermique (Rth,j) est montée entre deux des capacités thermiques (Cth,i),
**caractérisé en ce qu'**
après une phase d'arrêt, jusqu'à une durée maximum prédéfinie de l'accumulateur d'énergie (10) des valeurs de départ de la température (Ti,i = 1 à k) des températures des composants qui représentent des capacités thermiques (Cth,i), ne pouvant pas être détectées par la technique de mesure ou non détectées par la technique de mesure, sont prévues de façon assistée par calculateur pour l'utilisation du modèle thermique, et pour la prévision d'une valeur de départ de la température (Ti) après la phase d'arrêt, la valeur de la température concernée déterminée en dernier lieu avant la phase d'arrêt et une valeur de la température mesurée sont enregistrées, à la fin de la phase d'arrêt, la différence de température entre la valeur de la température mesurée enregistrée et la valeur de la température déterminée de manière assistée par ordinateur est calculée, la valeur de la température déterminée de manière assistée par ordinateur est corrigée avant la formation de la différence de température au moyen d'une courbe de décroissance prédéfinie et de la longueur de la phase d'arrêt, et la différence de température est ajoutée à la valeur de la température mesurée à la fin de la phase d'arrêt, la valeur de somme ainsi obtenue correspondant à la valeur de départ de la température (Ti).

2. Procédé conforme à la revendication 1, selon lequel dans le modèle thermique, on prend en considération les capacités thermiques (Cth,i) de l'enroulement cellulaire (2) d'au moins une cellule d'accumulation de l'accumulateur d'énergie (10), du boîtier (1) de cette cellule d'accumulateur (10), d'au moins une borne de connexion (3) de la cellule d'accumulateur et le cas échéant d'un dispositif de refroidissement (K).

3. Procédé conforme à l'une des revendications précédentes, selon lequel, dans le modèle thermique, on traite la puissance dissipée de l'accumulateur d'énergie (10) qui est déterminée à partir du courant dans l'accumulateur d'énergie (10) détecté par la technique de mesure.

4. Procédé conforme à l'une des revendications précédentes, selon lequel, au moins la température d'un composant de l'accumulateur d'énergie (10) qui représente l'une des capacités thermiques (Cth,i) à l'exception de l'enroulement cellulaire est déterminée par la technique de mesure et prise en considération dans le modèle thermique.

5. Procédé conforme à l'une des revendications précédentes, selon lequel pour le modèle thermique, on détermine par itération pour un pas de temps prédéfini ($\Delta t$) la quantité de chaleur ($Q_{i \to i+1}$) échangée entre deux capacités thermiques voisines (Cth,i) à partir de leur différence de température ($T_i - T_{i+1}$), avec la résistance thermique du pas de temps ($R_{th,i \to i+1}$) selon la formule suivante,

$$Q_{i \to i+1} = \frac{T_i - T_{i+1}}{R_{th,i \to i+1}} \Delta t$$

6. Procédé conforme à la revendication 1,
selon lequel pour le modèle thermique on détermine par itération à partir des quantités de chaleur échangées déterminées ($Q_k$) les températures ($T_i(t_0 + \Delta t)$) des capacités thermiques ($C_{th,i}$) pour chaque pas de temps prédéfini (i), avec le pas de temps prédéfini ($\Delta t$) selon la formule suivante :

$$T_i(t_0 + \Delta t) = T_i(t_0) + \frac{1}{C_{th,i}} \sum_{k=1}^{n} Q_k$$

7. Procédé conforme à l'une des revendications précédentes, selon lequel lors de la simulation, on utilise pour la correction d'erreur de la valeur de départ de la température ($T_i$), après la phase d'arrêt un observateur (20) par la technique de régulation.

8. Accumulateur d'énergie électrochimique (10) en particulier pour un véhicule comprenant un appareil de commande dans lequel est déposé un modèle thermique de l'accumulateur d'énergie (10), celui-ci étant réalisé pour permettre la mise en oeuvre d'un procédé conforme à l'une quelconque des revendications précédentes.

Fig. 1

Fig. 2

Fig. 3

**IN DER BESCHREIBUNG AUFGEFÜHRTE DOKUMENTE**

**In der Beschreibung aufgeführte Patentdokumente**

- WO 9734133 A1